# DEMANDE DE BREVET EUROPEEN

(11) **EP 3 342 304 A1**
(43) Date de publication de la demande: **04.07.2018**
(21) Numéro de dépôt: 16207506.3
(22) Date de dépôt: 30.12.2016
(51) Int. Cl.: A44C 5/10, A44C 27/00, B29C 67/00, G06F 17/50, G06T 17/00, B33Y 80/00

(54) **PROCEDE DE FABRICATION D'UN BRIN DE BRACELET**

(71) Demandeur: The Swatch Group Research and Development Ltd, 2074 Marin (CH)
(72) Inventeur: Ruegsegger, Alain, 2087 Cornaux (CH)
(74) Mandataire: Ravenel, Thierry Gérard Louis

(57) **Abrégé**

L'invention se rapporte à un procédé de fabrication d'un brin (100) de bracelet articulé, formé d'au moins deux maillons (1, 2, 3), comprenant les étapes suivantes :
- générer un fichier 3D du brin de bracelet ;
- convertir le fichier 3D en une pluralité de couche par le biais d'un logiciel, chaque couche représentant une coupe transversale du brin de bracelet ;
- former le brin de bracelet couche par couche au moyen d'une fabrication additive.

Selon l'invention, le fichier 3D comprend au moins un logement interne (10, 20) dans au moins un des maillons (1, 2), ledit logement étant agencé pour recevoir et maintenir un élément d'articulation (4), de manière à ce que lesdits au moins deux maillons forment un ensemble articulé indémontable.

## Description

### Domaine de l'invention

L'invention concerne un procédé de fabrication d'un bracelet, et plus précisément d'un bracelet à maillons pour pièce d'horlogerie.

### Arrière-plan de l'invention

Généralement, un bracelet comprend une pluralité de maillons qui sont fabriqués un à un et articulés entre eux, les deux bords d'un maillon étant assemblés contre les bords de maillons adjacents respectifs, des passages transversaux traversant au moins partiellement les maillons assemblés adjacents respectifs pour former des paliers dans lesquels des organes d'articulation sont engagés et maintenus aux deux extrémités des passages transversaux respectifs.

On connait du document EP 2 484 247 un tel bracelet comprenant un maillon assemblé comportant, de part et d'autre, au moins deux tels maillons équipés, et comportant au moins une entretoise comportant deux extrémités agencée pour coopérer, au niveau des deux extrémités, avec deux des maillons équipés. Un tel bracelet est long à fabriquer et assembler. Un tel bracelet nécessite également l'emploi d'un outil pour effectuer le montage et le réglage de la longueur.

### Résumé de l'invention

L'invention a notamment pour objectif de pallier les différents inconvénients de ces techniques connues.

Plus précisément, un objectif de l'invention est de fournir un procédé de fabrication d'un bracelet à maillons permettant de réaliser le bracelet en une seule fois à la longueur désirée.

L'invention a également pour objectif, au moins dans un mode de réalisation particulier, de fournir un procédé de fabrication qui permette de réduire drastiquement le temps de fabrication d'un bracelet, qui soit simple à mettre en oeuvre et peu coûteux.

Ces objectifs, ainsi que d'autres qui apparaîtront plus clairement par la suite, sont atteints selon l'invention à l'aide d'un de fabrication d'un brin de bracelet articulé, formé d'au moins deux maillons, comprenant les étapes suivantes :
- générer un fichier 3D du brin de bracelet ;
- convertir le fichier 3D en une pluralité de couche par le biais d'un logiciel, chaque couche représentant une coupe transversale du brin de bracelet ;
- former le brin de bracelet couche par couche au moyen d'une fabrication additive.

Selon l'invention, le fichier 3D comprend au moins une cavité interne dans au moins un des maillons, la cavité étant agencée pour recevoir un élément d'articulation, de manière à ce que lesdits au moins deux maillons forment un ensemble imperdable et indémontable.

Ainsi, l'objet de la présente invention, par ses différents aspects fonctionnels et structurels décrits ci-dessus, permet d'obtenir un bracelet facile et rapide à fabriquer.

Conformément à d'autres variantes avantageuses de l'invention :
- le moyen d'articulation comprend une tige cylindrique recevant une excroissance à chacune de ses extrémités, chaque excroissance étant agencée pour reposer dans ledit au moins un logement ;
- au moins un maillon comprend une portée cylindrique agencée pour recevoir ladite tige dudit élément d'articulation ;
- ledit au moins un logement comprend une section de diamètre D, et ladite portée une deuxième section de diamètre d inférieur au diamètre D de la section dudit logement ;
- Le procédé comprend une étape de lavage du brin de bracelet formé, le brin de bracelet étant immergé dans une solution ;
- la fabrication additive est réalisée au moyen de la technologie Multi-Jet Modeling.

L'invention concerne également un brin de bracelet obtenu par le procédé conforme à l'invention.

### Description sommaire des dessins

D'autres caractéristiques et avantages de l'invention apparaîtront plus clairement à la lecture de la description suivante d'un mode de réalisation particulier de l'invention, donné à titre de simple exemple illustratif et non limitatif, et des figures annexées, parmi lesquelles :
- la figure 1 est une vue en coupe sagittale de plusieurs maillons articulés entre eux pour former un brin de bracelet conforme à l'invention ;
- les figures 2a et 2b sont respectivement des vues en coupe longitudinale d'un brin de bracelet conforme à l'invention selon un premier et un deuxième mode de réalisation ;

### Description détaillée des modes de réalisation préférés

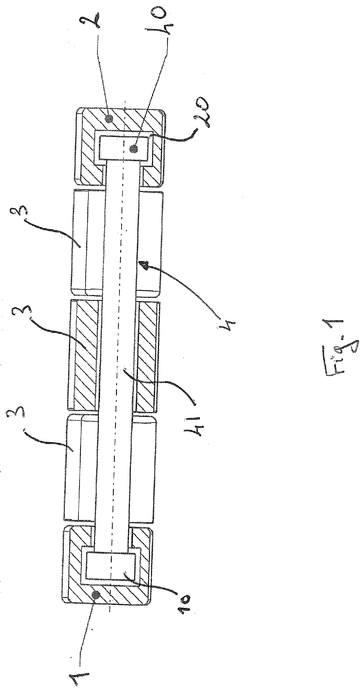

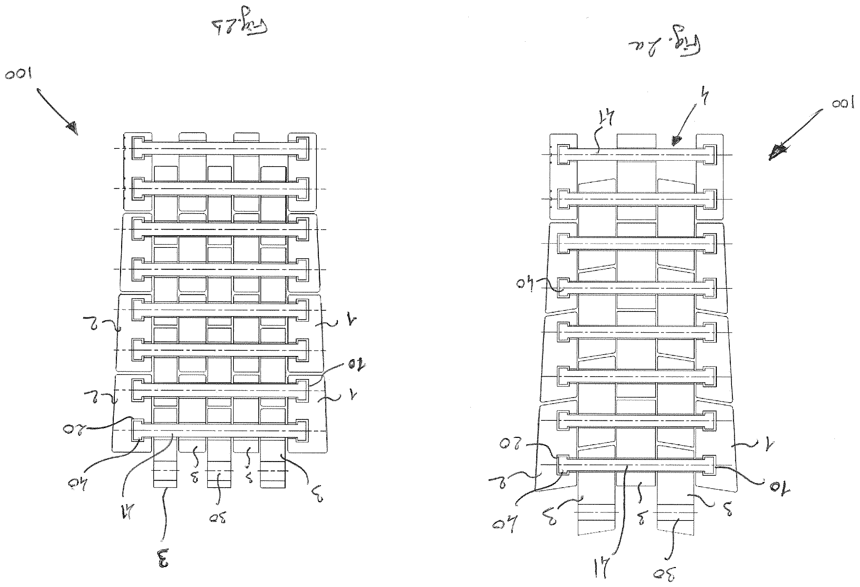

Un procédé de fabrication d'un brin de bracelet à maillons ainsi que le brin de bracelet issu d'un tel procédé va maintenant être décrit dans ce qui suit faisant référence conjointement aux figures 1, 2a et 2b

L'invention est décrite ici avec le cas simplifié et non limitatif de deux éléments de maillon complémentaires mobiles l'un par rapport à l'autre, et il est naturellement possible de réaliser un brin de bracelet selon l'invention comportant davantage d'éléments de maillon mobiles entre eux.

L'assemblage d'une pluralité de maillons articulés pour former un bracelet est illustré aux figure 2a et 2b, où chaque maillon est articulé à un maillon adjacent par un élément d'articulation 4. Ce dernier est maintenu à ses extrémités dans des logements 10, 20 de diamètre D ménagés dans les maillons latéraux 1 et 2. La partie médiane de l'élément d'articulation 4 traverse une portée 30 sensiblement cylindrique de diamètre d ménagée dans le ou les maillon(s) intermédiaire(s) 3 adjacent(s) aux maillons latéraux, la portée 30 présentant une diamètre d inférieur au diamètre D du logement pour empêcher tout démontage.

Comme illustré à la figure 1, l'organe d'articulation 4 comprend, dans cet exemple, deux excroissances 40 de la forme d'un cylindre à section droite. Ces excroissances 40 sont disposées aux extrémités de l'élément d'articulation 4. L'élément d'articulation 4 se présente sous la forme d'une tige 41 présentant une section cylindrique droite, et vient se loger dans la portée 30 ménagée dans le ou les maillons intermédiaires 3. La tige 41 est maintenue entre les deux maillons latéraux 1 et 2, dans les logements 10 et 20 respectivement ménagés dans ceux-ci. Les extrémités de l'élément d'articulation 4 sont agencées pour reposer dans ces logements 10, 20. De préférence, les excroissances 40 présentent des dimensions légèrement inférieures aux dimensions des logements de manière à pouvoir pivoter.

La figure 2a illustre une vue de dessus sur plusieurs rangées de maillons d'un bracelet de montre selon l'invention. Chaque rangée est constituée dans cet exemple d'un maillon gauche 1, d'un maillon droit symétrique 2 et de trois maillons intermédiaires 3. L'invention n'est toutefois pas limitée à des bracelets comportant cinq maillons par rangée, il serait possible d'insérer d'autres maillons intermédiaires entre les maillons gauche et droit 1 et 2, ou plus simplement, d'utiliser un seul maillon par rangée. De même, l'invention n'est pas limitée à la forme particulière des maillons illustrés.

Les maillons de chaque rangée sont maintenus l'un contre l'autre entre une portion des maillons de la rangée suivante. La tige cylindrique 41 traverse tous les maillons intermédiaires 3 de la rangée par une ouverture 30 présentant un diamètre légèrement supérieur à celui de la tige 41, de manière à permettre un pivotement sans jeu des rangées de maillons les unes par rapport aux autres.

Un procédé pour la fabrication d'un tel brin de bracelet 1 selon un mode de réalisation préférentiel va être décrit dans ce qui suit.

Dans une première étape, un fichier du brin de bracelet 1 en trois dimensions est généré en fonction des dimensions souhaitées au moyen d'un logiciel de CAO.

Lors d'une deuxième étape, le fichier en trois dimensions est converti de manière à créer un nombre prédéterminés de couches d'une épaisseur choisie, et peut par exemple être comprise entre 16 µm et 27 µm, chaque couche représentant une coupe transversale du brin 100 de bracelet. Bien évidemment, l'épaisseur des couches peut varier en fonction de l'équipement et de la technologie pour réaliser la fabrication additive.

Selon une étape optionnelle du procédé de fabrication, la position et l'orientation du brin de bracelet est choisie avant de définir le nombre et l'épaisseur des couches.

Ensuite, on forme le brin de bracelet 100 couche par couche au moyen d'une fabrication additive. De préférence, la fabrication additive est réalisée au moyen de la technologie Multi-Jet Modeling (MJM) qui est basée sur le principe de la photo-polymérisation de matière sous l'effet d'une exposition aux rayons ultraviolets telle qu'une résine photopolymère par exemple. La tête d'impression projette préalablement une résine photopolymère et une matière support sur un plateau mobile ou fixe.

Bien évidemment, d'autres technologies de fabrication additive bien connues de l'homme du métier peuvent être utilisées pour la fabrication d'un tel brin de bracelet.

Ainsi, le brin de bracelet 100 est fabriqué par jets successifs, couche après couche, à partir de photopolymères sur une surface. De plus, la technologie Multi-Jet Modeling permet d'injecter un matériau de support amovible de type gel pour combler les espaces/cavités ne recevant pas de matière photopolymère.

De manière avantageuse, l'élément d'articulation 4 est formé en même temps que les maillons de telle manière que la tige 41 et les excroissances 40 de l'élément d'articulation 4 viennent respectivement reposer dans la portée 30 ménagée dans le ou les maillons intermédiaires 3 et dans les logements 10, 20 des maillons latéraux 1 et 2.

Enfin, une fois le brin de bracelet terminé, celui-ci est immergé, dans une solution liquide de manière à éliminer le matériau support dans le cas de la technologie Multi-Jet Modeling. Le matériau de support est généralement un gel qui est retiré en immergeant le brin de bracelet dans une solution.

De préférence, la solution utilisée est mélange eau et solution basique de PH 14 de concentration 5%.

Grâce à ces différents aspects de l'invention, on dispose d'un brin de bracelet facilement et rapidement fabricable, et dont la longueur peut être adaptée au poignet de l'utilisateur lors de la fabrication.

Bien entendu, la présente invention ne se limite pas à l'exemple illustré et est susceptible de diverses variantes et modifications qui apparaîtront à l'homme de l'art.

## Revendications

1. Procédé de fabrication d'un brin de bracelet articulé, formé d'au moins deux maillons, comprenant les étapes suivantes :
- générer un fichier 3D du brin de bracelet ;
- convertir le fichier 3D en une pluralité de couche par le biais d'un logiciel, chaque couche représentant une coupe transversale du brin de bracelet ;
- former le brin de bracelet couche par couche au moyen d'une fabrication additive ;
**caractérisé en ce que** le fichier 3D comprend au moins un logement interne dans au moins un des maillons, ledit logement étant agencé pour recevoir et maintenir un élément d'articulation, de manière à ce que lesdits au moins deux maillons forment un ensemble articulé indémontable.

2. Procédé de fabrication selon la revendication 1, dans lequel ledit moyen d'articulation (4) comprend une tige cylindrique (41) recevant une excroissance (40) à chacune de ses extrémités, chaque excroissance étant agencée pour reposer dans ledit au moins un logement.

3. Procédé de fabrication selon la revendication 1 ou 2, dans lequel au moins un maillon comprend une portée cylindrique agencée pour recevoir ladite tige (41) dudit élément d'articulation.

4. Procédé de fabrication selon l'une des revendications 1 à 3, dans lequel ledit au moins un logement comprend une section de diamètre D, et ladite portée une deuxième section de diamètre d inférieur au diamètre D de la section dudit logement.

5. Procédé de fabrication selon la revendication 1, comprenant une étape de lavage du brin de bracelet (100) formé, le brin de bracelet étant immergé dans une solution.

6. Procédé de fabrication selon l'une des revendications 1 à 5, dans lequel la fabrication additive est réalisée au moyen de la technologie Multi-Jet Modeling.

7. Brin de bracelet (100) obtenu par le procédé selon les revendications 1 à 6.
